# EUROPEAN PATENT SPECIFICATION

(11) **EP 2 693 770 B1**
(45) Date of publication and mention of the grant of the patent: **02.12.2020**
(21) Application number: 13003696.5
(22) Date of filing: 23.07.2013
(51) Int. Cl.: H04R 7/10, H04R 7/20, H04R 9/04

(54) **Suspension for a sound transducer**
Aufhängung für einen Schallwandler
Suspension pour un transducteur acoustique

(30) Priority: 30.07.2012 KR 20120082971
(43) Date of publication of application: 05.02.2014
(73) Proprietor: Em-tech. Co., Ltd., Busan 609-390 (KR)
(72) Inventor: Kwon, Joong Hak, Busan, 609-843 (KR); Jeong, Ho II, 730-380 Gyeongsangbuk-do (KR); Choi, Kyu Dong, 641-270 Gyeongsangnam-do (KR); Jeong, In Ho, 641-756 Gyeongsangnam-do (KR)
(74) Representative: Müller Hoffmann & Partner

(56) References cited:
- WO-A2-2012/023709
- US-A1- 2004 008 860
- US-A1- 2006 215 874

## Description

### TECHNICAL FIELD

The present invention relates to a suspension for a sound transducer, and more particularly, to a suspension for a sound transducer which is made of an FPCB to transfer electrical signals to a voice coil and which has a central portion serving as a center diaphragm.

### BACKGROUND ART

Sound reproducing technologies of mobile multimedia have been developed along with mobile communication technologies, which require high performance, high sound quality, and high output of a microspeaker.

In most cases, a conventional microspeaker does not employ a suspension so as to achieve a light weight of a diaphragm, and a lead wire of a voice coil is bonded to the diaphragm so that external electrical signals can be applied to the voice coil. Thus, a partial vibration often occurs due to the absence of the suspension, and the lead wire of the coil is often down due to a tensile force in high outputs, which makes it difficult to use the microspeaker in high output applications.

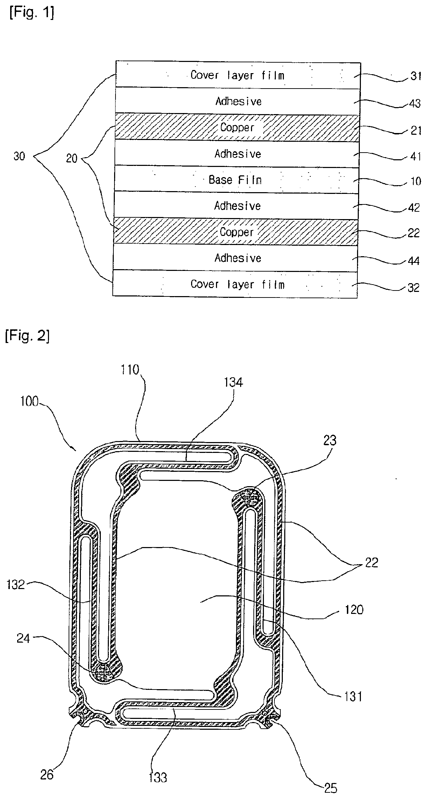

In order to solve the foregoing problem, a microspeaker has been suggested that uses a suspension made of an FPCB with a conductive pattern for transferring electrical signals. FIG. 1 shows a general suspension made of an FPCB, wherein a conductive film 20 made of copper or the like is disposed on a base film 10 made of a PI having good thermal properties, and a cover layer 30 is attached thereon to protect the conductive film 20. In addition, the base film 10, the conductive film 20 and the cover layer 30 are attached to one another by means of adhesives 41, 42, 43 and 44.

With respect to the microspeaker using the suspension, an increase in weight of the vibration system, which results from the application of the suspension, causes a decrease in sound pressure of the microspeaker. Additionally, cracks may be formed on the conductive film 20 in high outputs, which leads to defects. In order to prevent a decrease in sound pressure, it is possible to reduce the weight of the vibration system by appropriately adjusting the shapes of the cover layer 30 and the conductive film 20 of the suspension. However, as the diaphragm gets thinner, a local vibration mode of the diaphragm occurs in high frequency regions, which has a detrimental effect on sound properties. Therefore, it is necessary to appropriately adjust the shapes of the cover layer 30 and the conductive film 20 to prevent such a local vibration mode.

US 2006/0215874 A1 and WO 2012/023709 A2 disclose prior art relevant to the subject-matter of this application.

### DISCLOSURE OF THE INVENTION

An object of the present invention is to provide a suspension for a sound transducer which has a central portion serving as a center diaphragm and which has a cover layer and a copper pattern partially removed to prevent a decrease in sound pressure from being caused by an increase in weight of a vibration system.

Another object of the present invention is to provide a suspension for a sound transducer which can achieve a light weight by adjusting the shapes of a cover layer and a copper pattern.

The objects are solved by a suspension for a sound transducer according to claim 1.

According to an aspect of the present invention for achieving the above objects, there is provided a suspension for a sound transducer which includes a central portion, a peripheral portion, and a support portion for connecting the central portion to the peripheral portion, the suspension comprising: a base film, a conductive film attached on the base film by means of an adhesive, and a cover layer attached on the conductive film by an adhesive, at least part of the cover layer disposed on the central portion being removed.

In addition, at least part of the cover layer disposed on the support portion is removed.

Moreover, the support portions are provided in four directions, respectively, which include a pair of long support portions and a pair of short support portions, the cover layer disposed on the long support portions is entirely removed, and only parts of the cover layer disposed on the short support portions that are adjacent to the central portion are removed.

Additionally, the conductive film disposed on the central portion is entirely removed, except part of the periphery of the central portion

Furthermore, the conductive film and the cover layer are attached to both faces of the base film, and only the cover layer on the central portion that is attached to one face is removed.

Still furthermore, the conductive film and the cover layer are attached to both faces of the base film, and at least parts of the respective cover layers on the central portion are removed.

Still furthermore, the conductive film and the cover layer are attached to both faces of the base film, and the cover layers on the central portion that are attached to both faces are entirely removed.

Still furthermore, a center part of the cover layer disposed on the central portion is removed, except its periphery.

Still furthermore, plural parts of the cover layer disposed on the central portion are removed so that the removed parts can be formed in a stripe shape, spaced apart from one another.

Still furthermore, the cover layer disposed on the central portion is removed so that the removed part can be formed in a lattice shape.

Still furthermore, the cover layer disposed on the central portion is removed so that the removed part can be formed in a fishbone shape.

Still furthermore, the cover layer disposed on the central portion is removed so that the removed part can include a center-removed part and a ring-shaped part enclosing the center-removed part with a gap.

Still furthermore, the metal film disposed on the central portion is provided in such a shape that a split vibration does not occur in high frequency regions by the removed part of the cover layer.

The suspension for the sound transducer provided by the present invention can improve a sound pressure by removing part of the cover layer attached on the central portion to achieve a light weight of the vibrating portion.

In addition, the suspension for the sound transducer provided by the present invention can prevent a fatigue fracture of the metal film, which is caused by a difference in contraction and expansion ratio of the cover layer and the metal film, by removing the cover layer on one face of the support portion.

Moreover, the suspension for the sound transducer provided by the present invention can prevent a partial vibration from occurring in low frequencies due to a decrease in a supporting force of the suspension, by removing only parts of the cover layer attached on the short support portions that are adjacent to the central portion.

Additionally, the suspension for the sound transducer provided by the present invention can improve a sound pressure by achieving a light weight of the vibrating portion, by minimizing the area of the metal film attached on the central portion.

Furthermore, the suspension for the sound transducer provided by the present invention can prevent a split mode in high frequency regions, by forming the metal film, which is attached on the central portion, in a shape corresponding to the shape of the removed part of the cover layer.

### BRIEF DESCRIPTION OF THE DRAWINGS

FIG. 1 is a sectional view showing a conventional suspension for a sound transducer.
FIG. 2 is a view showing a lower pattern of a metal film provided in a suspension according to a first embodiment of the present invention.
FIG. 3 is a view showing a state where part of an upper cover layer of the suspension according to the first embodiment of the present invention is removed.
FIG. 4 is a schematic sectional view showing a stale where the upper cover layer on the central portion of the suspension according to the first embodiment of the present invention is removed.
FIG. 5 is a schematic sectional view showing a state where both the upper and lower cover layers of the suspension according to the first embodiment of the present invention are removed.
FIG. 6 is a schematic sectional view showing a state where both the upper and lower cover layers, in positions to which upper and lower metal films are not attached, of the central portion of the suspension according to the first embodiment of the present invention are removed.
FIG. 7 is a view showing a state where part of an upper cover layer of a suspension according to a second embodiment of the present invention is removed,
FIG. 8 is a view showing a state where part of an upper cover layer of a suspension according to a third embodiment of the present invention is removed.
FIG. 9 is a view showing a state where part of an upper cover layer of a suspension according to a fourth embodiment of the present invention is removed.
FIG. 10 is a view showing a state where part of an upper cover layer of a suspension according to a fifth embodiment of the present invention is removed.
FIG. 11 is a view showing a state where part of an upper cover layer of a suspension according to a sixth embodiment of the present invention is removed.
FIG. 12 is a view showing a state where part of an upper cover layer of a suspension according to a seventh embodiment of the present invention is removed.

### BEST MODE FOR CARRYING OUT THE INVENTION

Hereinafter, the present invention will be described in more detail with reference to the drawings.

FIG. 2 is a view showing a lower pattern of a metal film provided in a suspension according to a first embodiment of the present invention. As in the conventional suspension shown in FIG. 1, basically in the suspension according to the first embodiment of the present invention, metal films 20 are attached to upper and lower portions of a base film 10, and cover layers 30 are attached thereon to protect the metal films 20. The base film 10 of the suspension includes a central portion 120, a peripheral portion 110, and support portions 131 , 132, 133 and 134 which connect the central portion 120 to the peripheral portion 110. An inner circumference of a side diaphragm (not shown) and a voice coil (not shown) are attached to the central portion 120, and an outer circumference of the side diaphragm (not shown) is attached to the peripheral portion 110. The peripheral portion 110 is formed in a ring shape with a gap from the central portion 120 and seated on a frame (not shown). The support portions 131, 132, 133 and 134 allow the central portion 120 to vibrate only in the vertical direction, when it vibrates due to the vibration of the voice coil (not shown).

A pair of lower metal films 22, which are separated from each other, are attached to the lower portion of the base film 10 (see FIG. 1), so that their (+) and (-) poles can be connected to lead-in wires of the voice coil, respectively. The lower metal films 22 are provided to be connected to the peripheral portion 110, the support portion 130 and the central portion 120, terminal lands 25 and 26 for connection to terminals for transferring electrical signals from an external device are formed at one side of the peripheral portion 110, and voice coil lands 23 and 24 are provided to solder the lead-in wires of the voice coil to the support portion 130 or the central portion 120. A cover layer 32 for protecting the metal film 22 is attached on the metal film 22, but is not provided on the terminal lands 25 and 26 and the voice coil lands 23 and 24 for the purpose of soldering.

Meanwhile, the lower metal films 22 are disposed along the periphery of the central portion 120, so that the lower metal films 20 formed on the neighboring support portions 132 and 134; 131 and 133 can be connected to each other. That is to say, the sound transducer generally formed in a rectangular shape has a pair of long sides and a pair of short sides, as all the components such as the diaphragm, suspension, magnetic circuit, etc. are formed in a rectangular shape. Thus, the support portions 131, 132, 133 and 134 also include long support portions 131 and 132, which are disposed on the long sides, and short support portions 133 and 134, which are disposed on the short sides. In turn, the metal films 22, which are formed on the neighboring long support portions 131 and 132 and short support portions 133 and 134, are connected to each other. The lower metal film 22, which connects the lower metal film 22 formed on the long support portion 131 and 132 to the lower metal film 22 formed on the short support portion 133 and 134, is disposed on both the peripheral portion 110 and the central portion 120. Here, the lower metal film 22, which connects the lower metal film 22 formed on the long support portion 131 and 132 disposed on the central portion to the lower metal film 22 formed on the short support portion 133 and 134 is preferably disposed on the long side of the central portion 120. The lower metal film 22 is disposed along the periphery of the long side of the central portion 120, thereby preventing a split vibration of the central portion 120 that may occur when the cover layer attached on the central portion 120 is removed, as discussed later.

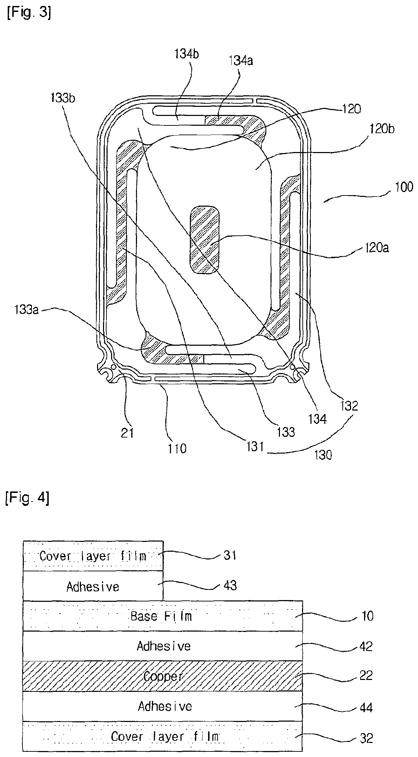

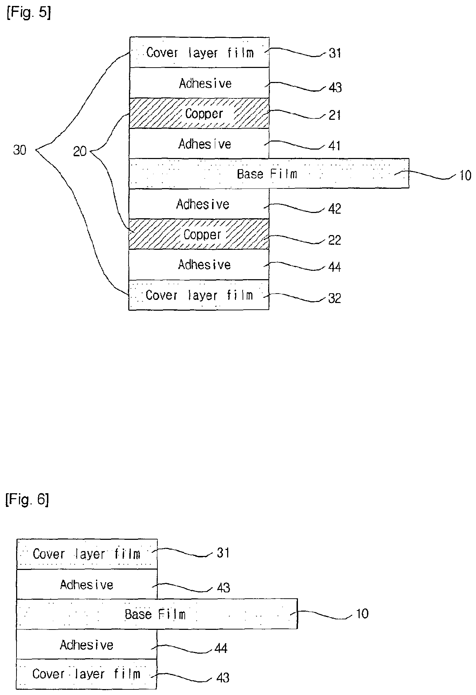

FIG. 3 is a view showing a state where part of an upper cover layer of the suspension according to the first embodiment of the present invention is removed. In the suspension 100 according to the first embodiment of the present invention, an upper metal film 21 is disposed along the peripheral portion 110 on the base film 10 (see FIG. 5). In addition, an upper cover layer 31 (see FIG. 5) is attached on the upper metal film 21 to protect the upper metal film 21. Here, since the upper metal film 21 is provided only on the peripheral portion 110 of the suspension 100, the upper cover layer 31 (see FIG. 5) attached on the central portion 120 or the support portion 130 can be removed to reduce a weight. As described above, the central portion 120 or the support portion 130 is a vibrating portion, which vibrates when the voice coil (not shown) attached to the central portion 120 vibrates, in particular, the central portion 120 serves as a center diaphragm, and therefore reducing the weight of the vibrating portion is advantageous to improve a sound pressure.

The removed part of the upper cover layer 31 (see FIG. 5) is indicated by the shaded section in FIG. 3. There are a central portion-removed part 120a formed by removing the upper cover layer 31 (see FIG. 5) from the center of the central portion 120, and a central portion-remaining part 120b where the upper cover layer 31 (see FIG. 5) still remains. Moreover, with respect to the upper cover layer 31 (see FIG. 5) disposed on the support portion 130, the upper cover layer attached on the long support portions 131 and 132 is entirely removed, parts of the upper cover layer attached on the short support portions 133 and 134 that are adjacent to the central portion 120 become removed parts 133a and 134a, and the other parts 133b and 134b that are adjacent to the peripheral portion 110 become remaining parts 133b and 134b.

FIG. 4 is a schematic sectional view showing a state where both the upper cover layer on the central portion of the suspension according to the first embodiment of the present invention is removed, FIG. 5 is a schematic sectional view showing a state where both the upper and lower cover layers of the suspension according to the first embodiment of the present invention are removed, and FIG. 6 is a schematic sectional view showing a state where both the upper and lower cover layers, in positions to which upper and lower metal films are not attached, of the central portion of the suspension according to the first embodiment of the present invention are removed. The upper metal film 21 and the lower metal film 22 are attached to upper and lower portions of the base film 10 by adhesives 41 and 42, the upper cover layer 31 is attached on the upper metal film 21 by an adhesive 43, and the lower cover layer 32 is attached on the lower metal film 22 by an adhesive 44. Here, since the upper metal film 21 is provided only on the peripheral portion 110 of the suspension 100, the lower cover layer 32 attached on the central portion 120 can be removed to reduce a weight. The central portion 120 or the support portion 130 is a vibrating portion, which vibrates when the voice coil (not shown) attached to the central portion 120 vibrates, and therefore reducing the weight of the vibrating portion is advantageous to improve a sound pressure. Since the lower metal film 22 attached on the central portion 120 is provided only on the periphery of the long sides of the central portion 120, the lower cover layer 32 attached on the central portion 120 is preferably removed to reduce the weight of the vibrating portion, except the lower metal film 22-attached part.

The central portion-removed part 120a (see FIG. 3) formed by removing the upper cover layer 31 from the center of the central portion 120 has a sectional shape shown on the right side of FIG. 5, where the upper and lower conductive films 21 and 22 and the upper and lower cover layers 31 and 32 are entirely removed from the upper and lower portions of the base film 10. On the contrary, the peripheral portion 110 has a sectional shape shown on the left side of FIG. 5, where the upper and lower conductive films 21 and 22 and the upper and lower cover layers 31 and 32 entirely remain on the upper and lower portions of the base film 10 in an attached manner.

Further, the removed parts 131, 132, 133a and 134a formed by removing the upper cover layer 31 from the support portion 130 have a sectional shape shown on the right side of FIG. 4, where the lower metal film 22 and the lower cover layer 32 remain on the base film 10, and the upper metal film 21 and the upper cover layer 31 are removed. Furthermore, the remaining parts 133b and 134b, where the upper cover layer 31 still remains on the support portion 130, have a sectional shape shown on the left side of FIG. 4, where the lower metal film 22, the lower cover layer 32 and the upper cover layer 31 are attached on the base film 10.

Additionally, the remaining part 120b (see FIG. 3), where the upper cover layer 31 remains on the central portion 120, has a sectional shape shown on the right side of FIG. 6, where the upper and lower cover layers 31 and 32 are attached to the upper and lower portions of the base film 10. However, the periphery of the central portion 120, where the lower metal film 22 is formed, has a sectional shape shown on the left side of FIG. 4, where the lower metal film 22, the lower cover layer 32 and the upper cover layer 31 are attached on the base film 10.

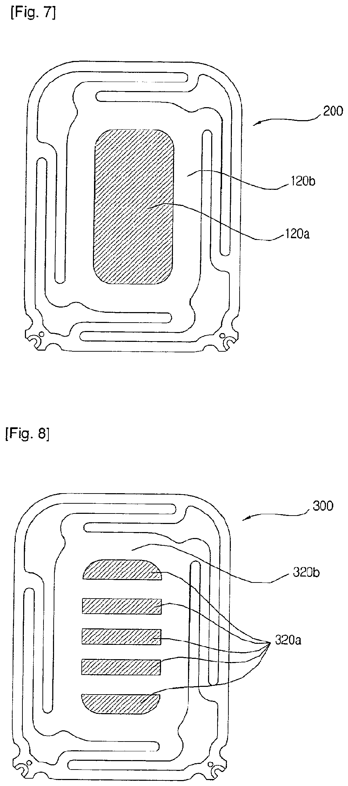

FIG. 7 is a view showing a state where part of an upper cover layer of a suspension according to a second embodiment of the present invention is removed. The suspension 200 according to the second embodiment of the present invention includes a central portion-removed part 220a and a central portion-remaining part 220b as in the first embodiment, but the central portion-removed part 220a is larger than that of the first embodiment. The lower conductive film 22 (see FIG. 2) may be provided identical to that of the first embodiment shown in FIG. 2, or the lower conductive film 22 may not be provided on the central portion 120 (see FIG. 2) but on the peripheral portion 110 (see FIG. 2) and the support portion 130 (see FIG. 2). In addition, the cover layer of the support portion 130 may be removed as in the first embodiment or may remain as it is.

FIG. 8 is a view showing a state where part of an upper cover layer of a suspension according to a third embodiment of the present invention is removed. The suspension 300 according to the third embodiment of the present invention includes a central portion-removed part 320a and a central portion-remaining part 320b as in the first embodiment, but the central portion-removed part 320a is different in shape from that of the first embodiment. A plurality of central portion-removed parts 320a are provided on the short side of the suspension 300 in the form of parallel stripes, spaced apart from one another. The lower conductive film 22 (see FIG. 2) may be provided identical to that of the first embodiment shown in FIG. 2, or the lower conductive film 22 may not be provided on the central portion 120 (see FIG. 2) but on the peripheral portion 110 (see FIG. 2) and the support portion 130 (see FIG. 2). In addition, the cover layer of the support portion 130 may be removed as in the first embodiment or may remain as it is.

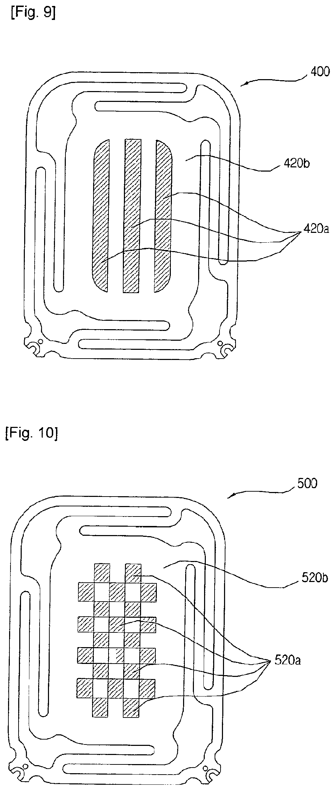

FIG. 9 is a view showing a state where part of an upper cover layer of a suspension according to a fourth embodiment of the present invention is removed. The suspension 400 according to the fourth embodiment of the present invention includes a central portion-removed part 420a and a central portion-remaining part 420b as in the first embodiment, but the central portion-removed part 420a is different in shape from that of the first embodiment. A plurality of central portion-removed parts 420a are provided on the long side of the suspension 400 in the form of parallel stripes, spaced apart from one another. The lower conductive film 22 (see FIG. 2) may be provided on the periphery of the central portion 120 (see FIG. 2) as in the first embodiment shown in FIG. 2, or the lower conductive film 22 may not be provided on the central portion 120 (see FIG. 2) but on the peripheral portion 110 (see FIG. 2) and the support portion 130 (see FIG. 2). In addition, the cover layer of the support portion 130 may be removed as in the first embodiment or may remain as it is.

FIG. 10 is a view showing a state where part of an upper cover layer of a suspension according to a fifth embodiment of the present invention is removed. The suspension 500 according to the fifth embodiment of the present invention includes a central portion-removed part 520a and a central portion-remaining part 520b as in the first embodiment, but the central portion-removed part 520a is different in shape from that of the first embodiment. The removed shape of the central portion-removed part 520a is a lattice shape. The lower conductive film 22 (see FIG. 2) may be provided on the periphery of the central portion 120 (see FIG. 2) as in the first embodiment shown in FIG. 2, or the lower conductive film 22 may not be provided on the central portion 120 (see FIG. 2) but on the peripheral portion 110 (see FIG. 2) and the support portion 130 (see FIG. 2). In addition, the cover layer of the support portion 130 may be removed as in the first embodiment or may remain as it is.

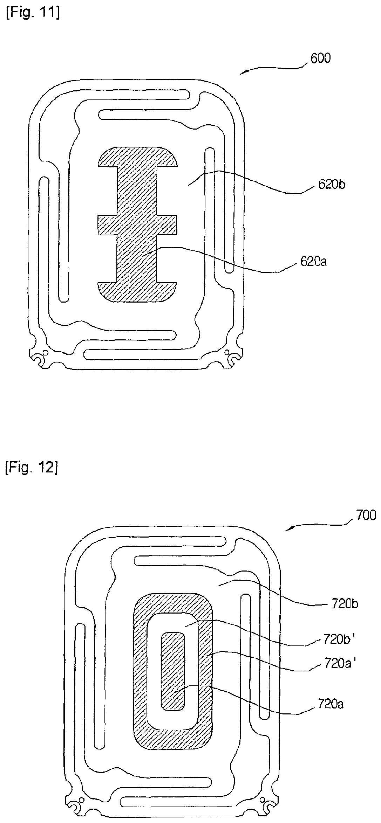

FIG. 11 is a view showing a state where part of an upper cover layer of a suspension according to a sixth embodiment of the present invention is removed. The suspension 600 according to the sixth embodiment of the present invention includes a central portion-removed part 620a and a central portion-remaining part 620b as in the first embodiment, but the central portion-removed part 620a is different in shape from that of the first embodiment. The central portion-removed part 620a is formed in a fishbone shape. That is, a plurality of central portion-removed parts 620a are provided such that linearly-removed parts parallel to the long side of the suspension 600 can cross the removed parts parallel to the short side of the suspension 600. The lower conductive film 22 (see FIG. 2) may be provided on the periphery of the central portion 120 (see FIG. 2) as in the first embodiment shown in FIG. 2, or the lower conductive film 22 may not be provided on the central portion 120 (see FIG. 2) but on the peripheral portion 110 (see FIG. 2) and the support portion 130 (see FIG. 2). In addition, the cover layer of the support portion 130 may be removed as in the first embodiment or may remain as it is.

FIG. 12 is a view showing a state where part of an upper cover layer of a suspension according to a seventh embodiment of the present invention is removed. The suspension 700 according to the seventh embodiment of the present invention includes a central portion-removed part and a central portion-remaining part as in the first embodiment, but the central portion-removed part is different in shape from that of the first embodiment. The central portion-removed part includes an inner removed part 720a, and an outer removed part 720a' which is formed in a ring shape to enclose the inner removed part 720a with a gap. The remaining part also includes an inner remaining part 720b' disposed between the inner removed part 720a and the outer removed part 720 a' and an outer remaining part 720b disposed outside the outer removed part 720a'. The lower conductive film 22 (see FIG. 2) may be provided on the periphery of the central portion 120 (see FIG. 2) as in the first embodiment shown in FIG. 2, or the lower conductive film 22 may not be provided on the central portion 120 (see FIG. 2) but on the peripheral portion 110 (see FIG. 2) and the support portion 130 (see FIG. 2). In addition, the cover layer of the support portion 130 may be removed as in the first embodiment or may remain as it is.

## Claims

1. A suspension (100 - 700) for a sound transducer that comprises a base film (10) including a central portion (120), a peripheral portion (110) formed in a ring shape with a gap from the central portion (120), and a plurality of support portions (131, 132, 133, 134) for connecting the central portion (120) to the peripheral portion (110),
the suspension (100 - 700) comprising: a conductive film (20, 21, 22) attached on the base film (10) by means of an adhesive (41, 42), **characterized by** a cover layer (30, 31, 32) attached on the conductive film (20, 21, 22) by an adhesive (43, 44) to protect the conductive film (20, 21, 22),
wherein at least part of the cover layer (30, 31, 32) disposed on the central portion (120) is removed.

2. The suspension (100 - 700) for the sound transducer as claimed in claim 1,
wherein at least part of the cover layer (30, 31, 32) disposed on the support portions (131, 132, 133, 134) is removed.

3. The suspension (100 - 700) for the sound transducer as claimed in claim 2,
wherein the support portions (131, 132, 133, 134) are provided in four directions, respectively, which include a pair of long support portions (131, 132) and a pair of short support portions (133, 134), the cover layer (30, 31, 32) disposed on the long support portions (131, 132) is entirely removed, and only parts of the cover layer (30, 31, 32) disposed on the short support portions (133, 134) that are adjacent to the central portion (120) are removed.

4. The suspension (100 - 700) for the sound transducer as claimed in claim 1,
wherein the conductive film (20, 21, 22) disposed on the central portion (120) is entirely removed, except part of the periphery of the central portion (120).

5. The suspension (100 - 700) for the sound transducer as claimed in claim 1,
wherein the conductive film (20, 21, 22) and the cover layer (30, 31, 32) are attached to both faces of the base film (10), and only the cover layer (30, 31, 32) on the central portion (120) that is attached to one face is removed.

6. The suspension (100 - 700) for the sound transducer as claimed in claim 1,
wherein the conductive film (20, 21, 22) and the cover layer (30, 31, 32) are attached to both faces of the base film (10), and at least parts of the respective cover layers (30, 31, 32) on the central portion (120) are removed.

7. The suspension (100 - 700) for the sound transducer as claimed in claim 1,
wherein the conductive film (20, 21, 22) and the cover layer (30, 31, 32) are attached to both faces of the base film (10), and at least part of the cover layer (30, 31, 32) on the central portion (120) that is attached to one face is removed.

8. The suspension (100 - 700) for the sound transducer as claimed in claim 1,
wherein a center part of the cover layer (30, 31, 32) disposed on the central portion (120) is removed, except its periphery.

9. The suspension (100 - 700) for the sound transducer as claimed in claim 1,
wherein plural parts of the cover layer (30, 31, 32) disposed on the central portion (120) are removed so that the removed parts can be formed in a stripe shape, spaced apart from one another.

10. The suspension (100 - 700) for the sound transducer as claimed in claim 1,
wherein the cover layer (30, 31, 32) disposed on the central portion (120) is removed so that the removed part can be formed in a lattice shape.

11. The suspension (100 - 700) for the sound transducer as claimed in claim 1,
wherein the removed part of the cover layer (30, 31, 32) on the central portion (120) is removed in a fishbone shape that is having a plurality of central portion-removed parts (620a) provided such that linearly-removed parts parallel to a long side of the suspension (100 - 700) crosses removed parts parallel to a short side of the suspension (100 - 700).

12. The suspension (100 - 700) for the sound transducer as claimed in claim 1,
wherein the cover layer (30, 31, 32) disposed on the central portion (120) is removed so that the removed part can include an inner removed part and an outer removed part which is formed in a ring shape to enclose the inner removed part with a gap.

## Patentansprüche

1. Aufhängung (100 - 700) für einen Schallwandler, die einen Basisfilm (10) aufweist, umfassend ein zentrales Teil (120), ein Umfangsteil (110), das mit einem Spalt vom zentralen Teil (120) in Ringform ausgebildet ist, und eine Vielzahl an Tragteilen (131, 132, 133, 134) zum Verbinden des zentralen Teils (120) mit dem Umfangsteil (110),
wobei die Aufhängung (100 - 700) aufweist: einen leitfähigen Film (20, 21, 22), der mittels eines Klebstoffs (41, 42) an dem Basisfilm (10) angebracht ist,
**gekennzeichnet durch**
eine Deckschicht (30, 31, 32), die mittels eines Klebstoffs (43, 44) an dem leitfähigen Film (20, 21, 22) angebracht ist, um den leitfähigen Film (20, 21, 22) zu schützen,
wobei zumindest ein Teil der Deckschicht (30, 31, 32), die auf dem zentralen Teil (120) angeordnet ist, entfernt ist.

2. Aufhängung (100 - 700) für den Schallwandler nach Anspruch 1,
wobei zumindest ein Teil der Deckschicht (30, 31, 32), die auf den Tragteilen (131, 132, 133, 134) angeordnet ist, entfernt ist.

3. Aufhängung (100 - 700) für den Schallwandler nach Anspruch 2,
wobei die Tragteile (131, 132, 133, 134) jeweils in vier Richtungen vorgesehen sind, welche ein Paar lange Tragteile (131, 132) und ein Paar kurze Tragteile (133, 134) umfassen, die Deckschicht (30, 31, 32), die auf den langen Tragteilen (131, 132) angeordnet ist, vollständig entfernt ist und nur Teile der auf den kurzen Tragteilen (133, 134) angeordneten Deckschicht (30, 31, 32), die dem zentralen Teil (120) benachbart sind, entfernt sind.

4. Aufhängung (100 - 700) für den Schallwandler nach Anspruch 1,
wobei der leitfähige Film (20, 21, 22), der auf dem zentralen Teil (120) angeordnet ist, mit Ausnahme eines Teils des Umfangs des zentralen Teils (120) vollständig entfernt ist.

5. Aufhängung (100 - 700) für den Schallwandler nach Anspruch 1,
wobei der leitfähige Film (20, 21, 22) und die Deckschicht (30, 31, 32) an beiden Oberflächen des Basisfilms (10) angebracht sind und nur die Deckschicht (30, 31, 32) auf dem zentralen Teil (120), die an einer Oberfläche angebracht ist, entfernt ist.

6. Aufhängung (100 - 700) für den Schallwandler nach Anspruch 1,
wobei der leitfähige Film (20, 21, 22) und die Deckschicht (30, 31, 32) an beiden Oberflächen des Basisfilms (10) angebracht sind und zumindest Teile der jeweiligen Deckschichten (30, 31, 32) auf dem zentralen Teil (120) entfernt sind.

7. Aufhängung (100 - 700) für den Schallwandler nach Anspruch 1,
wobei der leitfähige Film (20, 21, 22) und die Deckschicht (30, 31, 32) an beiden Oberflächen des Basisfilms (10) angebracht sind und zumindest ein Teil der Deckschicht (30, 31, 32) auf dem zentralen Teil (120), die an einer Oberfläche angebracht ist, entfernt ist.

8. Aufhängung (100 - 700) für den Schallwandler nach Anspruch 1,
wobei ein zentraler Teil der Deckschicht (30, 31, 32), die auf dem zentralen Teil (120) angeordnet ist, mit Ausnahme dessen Umfangs entfernt ist.

9. Aufhängung (100 - 700) für den Schallwandler nach Anspruch 1,
wobei mehrere Teile der Deckschicht (30, 31, 32), die auf dem zentralen Teil (120) angeordnet ist, so entfernt sind, dass die entfernten Teile in Streifenform voneinander beabstandet ausgebildet sein können.

10. Aufhängung (100 - 700) für den Schallwandler nach Anspruch 1,
wobei die Deckschicht (30, 31, 32), die auf dem zentralen Teil (120) angeordnet ist, so entfernt ist, dass der entfernte Teil in einer Gitterform ausgebildet sein kann.

11. Aufhängung (100 - 700) für den Schallwandler nach Anspruch 1,
wobei der entfernte Teil der Deckschicht (30, 31, 32) auf dem zentralen Teil (120) in einer Fischgrätenform entfernt ist, die eine Vielzahl an im zentralen Teil entfernten Teilen (620a) aufweist, die so vorgesehen sind, dass ein zu einer langen Seite der Aufhängung (100 - 700) paralleler, linear entfernter Teil zu einer kurzen Seite der Aufhängung (100 - 700) parallele entfernte Teile kreuzt.

12. Aufhängung (100 - 700) für den Schallwandler nach Anspruch 1,
wobei die Deckschicht (30, 31, 32), die auf dem zentralen Teil (120) angeordnet ist, so entfernt ist, dass der entfernte Teil einen inneren entfernten Teil und einen äußeren entfernten Teil umfassen kann, der in einer Ringform so ausgebildet ist, dass er den inneren entfernten Teil mit einem Spalt umschließt.

## Revendications

1. Suspension (100-700) pour un transducteur sonore qui comprend un film de base (10) incluant une partie centrale (120), une partie périphérique (110) formée en une forme d'anneau avec un espace depuis la partie centrale (120), et une pluralité de parties de support (131, 132, 133, 134) pour relier la partie centrale (120) à la partie périphérique (110),
la suspension (100-700) comprenant : un film conducteur (20, 21, 22) fixé sur le film de base (10) à l'aide d'un adhésif (41, 42), **caractérisée par** une couche de recouvrement (30, 31, 32) fixée sur le film conducteur (20, 21, 22) par un adhésif (43, 44) pour protéger le film conducteur (20, 21, 22),
dans laquelle une partie au moins de la couche de recouvrement (30, 31, 32) disposée sur la partie centrale (120) est enlevée.

2. Suspension (100-700) pour le transducteur sonore comme revendiquée dans la revendication 1,
dans laquelle une partie au moins de la couche de recouvrement (30, 31, 32) disposée sur les parties de support (131, 132, 133, 134) est enlevée.

3. Suspension (100-700) pour le transducteur sonore comme revendiquée dans la revendication 2,
dans laquelle les parties de support (131, 132, 133, 134) sont prévues dans quatre directions, respectivement, qui incluent une paire de parties de support longues (131, 132) et une paire de parties de support courtes (133, 134), la couche de recouvrement (30, 31, 32) disposée sur les parties de support longues (131, 132) est entièrement enlevée, et des parties seulement de la couche de recouvrement (30, 31, 32) disposée sur les parties de support courtes (133, 134) qui sont adjacentes à la partie centrale (120) sont enlevées.

4. Suspension (100-700) pour le transducteur sonore comme revendiquée dans la revendication 1,
dans laquelle le film conducteur (20, 21, 22) disposé sur la partie centrale (120) est entièrement enlevé, sauf une partie de la périphérie de la partie centrale (120).

5. Suspension (100-700) pour le transducteur sonore comme revendiquée dans la revendication 1,
dans laquelle le film conducteur (20, 21, 22) et la couche de recouvrement (30, 31, 32) sont fixés aux deux faces du film de base (10), et seule la couche de recouvrement (30, 31, 32) sur la partie centrale (120) qui est fixée à une seule face est enlevée.

6. Suspension (100-700) pour le transducteur sonore comme revendiquée dans la revendication 1,
dans laquelle le film conducteur (20, 21, 22) et la couche de recouvrement (30, 31, 32) sont fixés aux deux faces du film de base (10), et des parties au moins des couches de recouvrement (30, 31, 32) respectives sur la partie centrale (120) sont enlevées.

7. Suspension (100-700) pour le transducteur sonore comme revendiquée dans la revendication 1,
dans laquelle le film conducteur (20, 21, 22) et la couche de recouvrement (30, 31, 32) sont fixés aux deux faces du film de base (10), et une partie au moins de la couche de recouvrement (30, 31, 32) sur la partie centrale (120) qui est fixée à une seule face est enlevée.

8. Suspension (100-700) pour le transducteur sonore comme revendiquée dans la revendication 1,
dans laquelle une partie centrale de la couche de recouvrement (30, 31, 32) disposée sur la partie centrale (120) est enlevée, sauf sa périphérie.

9. Suspension (100-700) pour le transducteur sonore comme revendiquée dans la revendication 1,
dans laquelle plusieurs parties de la couche de recouvrement (30, 31, 32) disposée sur la partie centrale (120) sont enlevées de telle sorte que les parties enlevées puissent être formées en forme de bande, espacées les unes des autres.

10. Suspension (100-700) pour le transducteur sonore comme revendiquée dans la revendication 1,
dans laquelle la couche de recouvrement (30, 31, 32) disposée sur la partie centrale (120) est enlevée de telle sorte que la partie enlevée puisse être formée en forme de treillis.

11. Suspension (100-700) pour le transducteur sonore comme revendiquée dans la revendication 1,
dans laquelle la partie enlevée de la couche de recouvrement (30, 31, 32) sur la partie centrale (120) est enlevée en une forme d'arête de poisson qui a une pluralité de parties (620a) enlevées de la partie centrale prévues de telle sorte que des parties enlevées linéairement parallèles à un côté long de la suspension (100-700) croisent des parties enlevées parallèles à un côté court de la suspension (100-700).

12. Suspension (100-700) pour le transducteur sonore comme revendiquée dans la revendication 1,
dans laquelle la couche de recouvrement (30, 31, 32) disposée sur la partie centrale (120) est enlevée de telle sorte que la partie enlevée puisse inclure une partie enlevée intérieure et une partie enlevée extérieure qui est formée en une forme d'anneau pour entourer la partie enlevée intérieure avec un espace.
